# EUROPÄISCHE PATENTANMELDUNG

(11) **EP 1 947 768 A2**
(43) Veröffentlichungstag der Anmeldung: **23.07.2008**
(21) Anmeldenummer: 08000082.1
(22) Anmeldetag: 04.01.2008
(51) Int. Cl.: H03K 17/96

(54) **Sensorelement für einen kapazitiven Berührungsschalter sowie Bedienungseinrichtung**

(30) Priorität: 16.01.2007 DE 202007000969 U
(71) Anmelder: E.G.O. ELEKTRO-GERÄTEBAU GmbH, D-75038 Oberderdingen (DE)
(72) Erfinder: Dorwarth, Ralf, Dr., 75038 Oberderdingen (DE)
(74) Vertreter: Patentanwälte Ruff, Wilhelm, Beier, Dauster & Partner

(57) **Zusammenfassung**

Ein Sensorelement (20, 120) für einen kapazitiven Berührungsschalter (13) weist einen Sensorelementkörper (19, 119) auf, der an einem ersten Ende eine erste Stirnfläche (21, 121) und an einem zweiten anderen Ende eine zweite Stirnfläche (22) aufweist und aus homogenem elastischen Material besteht. Die Form des Sensorelementkörpers (19, 119) weicht durch Ausnehmungen (24, 124) und Ausbuchtungen (26, 126) seiner Außenkontur von einer reinen Zylinderform ab, wobei sich die Ausnehmungen (24, 124) und Ausbuchtungen (26, 126) über die Länge des Sensorelementkörpers (19, 119) von der ersten zur zweiten Stirnfläche (22) erstrecken und wobei die Erstreckungsrichtung der Ausnehmungen und Ausbuchtungen schräg ist zur Mittellängsachse (28) des Sensorelementkörpers.

## Beschreibung

### Anwendungsgebiet und Stand der Technik

Die Erfindung betrifft ein Sensorelement für einen kapazitiven Berührungsschalter sowie eine Bedienungseinrichtung für ein Elektrogerät mit mehreren derartigen Sensorelementen.

Es ist aus dem Stand der Technik, beispielsweise der 102 50 395 A1 oder der EP 859 467 A1 bekannt, Sensorelemente für einen kapazitiven Berührungsschalter mit einem elastischen, elektrisch leitfähigen Sensorelementkörper auszubilden. Eine Stirnfläche bzw. Stirnseite des Sensorelementkörpers liegt dabei an der Unterseite einer Bedienfläche an und bildet an dieser Fläche eine Kondensatorplatte eines Kondensators bzw. den funktionalen Teil des Sensorelements. Die andere Stirnfläche liegt an einem Träger an und ist elektrisch kontaktiert. Dabei befindet sich der Sensorelementkörper zusammengedrückt zwischen Bedienfläche und Träger. Um bei einer Bedienungseinrichtung mit einer Vielzahl von Sensorelementen die notwendige Kraft zum Zusammendrücken bzw. die gesamte aufaddierte Federkraft nicht allzu groß werden zu lassen, ist im Stand der Technik gemäß der 102 50 395 A1 versucht worden, die Federkraft durch Querbohrungen zu reduzieren. Dies stellt jedoch einen erheblichen Aufwand dar.

### Aufgabe und Lösung

Der Erfindung liegt die Aufgabe zugrunde, ein eingangs genanntes Sensorelement sowie eine eingangs genannte Bedienungseinrichtung zu schaffen, mit denen Probleme des Standes der Technik vermieden werden können und insbesondere ein Sensorelement geschaffen werden kann, das leichter bzw. mit geringerer Federkraft zusammengedrückt werden kann.

Gelöst wird diese Aufgabe durch ein Sensorelement mit den Merkmalen des Anspruchs 1 sowie eine Bedienungseinrichtung mit mehreren derartigen Sensorelementen mit den Merkmalen des Anspruchs 11. Vorteilhafte sowie bevorzugte Ausgestaltungen der Erfindung sind Gegenstand der weiteren Ansprüche und werden im Folgenden näher erläutert. Der Wortlaut der Ansprüche wird dabei durch ausdrückliche Bezugnahme zum Inhalt der Beschreibung gemacht.

Es ist vorgesehen, dass der Sensorelementkörper an einem ersten Ende eine erste Stirnfläche und an einem zweiten anderen Ende, insbesondere am gegenüberliegenden Ende, eine zweite Stirnfläche aufweist. Des Weiteren besteht er aus weitgehend homogenem Material. Erfindungsgemäß weicht die Form des Sensorelementkörpers von einer reinen Zylinderform dadurch ab, dass Ausnehmungen und/oder Ausbuchtungen an seiner Außenkontur vorgesehen sind. Diese können beispielsweise nach Art von Rillen ausgebildet sein. Die Ausnehmungen und/oder Ausbuchtungen erstrecken sich über die Länge des Sensorelementkörpers hinweg in Richtung von der ersten Stirnfläche zur zweiten Stirnfläche, wobei eine Richtung dieser Erstreckung schräg ist zu einer Längsrichtung des Sensorelementkörpers bzw. schräg steht zu den Stirnflächen. Somit kann eine Materialreduzierung erfindungsgemäß nicht nur durch Ausnehmungen zwischen den Ausbuchtungen erfolgen mit der sich daraus zwingend ergebenen leichteren Zusammendrückbarkeit. Durch den schrägen Verlauf der Ausnehmungen und/oder Ausbuchtungen ist ein Zusammendrücken in einer Richtung entsprechend der Längsrichtung des Sensorelementkörpers bzw. senkrecht zu den Stirnflächen leichter möglich als bei geradem Verlauf. So kann eine Art verdrillter oder verdrehter Sensorelementkörper geschaffen werden.

In einer Ausgestaltung der Erfindung kann die vorgenannte Erstreckungsrichtung sämtlicher Ausnehmungen und/oder Ausbuchtungen den gleichen Schrägwinkel zur Längsachse des Sensorelementkörpers bzw. zu den Stirnflächen aufweisen. Ein solcher Winkel kann beispielsweise 15° bis 60° betragen, vorzugsweise etwa 20°.

In weiterer Ausgestaltung der Erfindung kann das Sensorelement einen Querschnitt aufweisen mit einer Kontur bzw. Form, die von einem Kreis abweicht. Dabei kann der Sensorelementkörper in Richtung zwischen den Stirnflächen einen zwar stets gleichen Querschnitt aufweisen, der sich allerdings entlang der Längsachse des Sensorelementkörpers stetig dreht, insbesondere dreht er sich gleichmäßig um eine Mittellängsachse, so dass eine Art vorgenannter verdrillter Sensorelementkörper entsteht. Ein Drehwinkel einer derartigen Verdrehung bzw. Verdrillung kann mindestens 30° betragen, vorteilhaft 45° bzw. 60°.

Die Form des Querschnitts kann regelmäßig sein, beispielsweise nach einer Art Sterns mit Zacken oder abgerundeten Ausbuchtungen und Ausnehmungen zwischen den Ausbuchtungen. Dabei können vier bis zehn solcher Zacken bzw. Ausbuchtungen vorgesehen sein oder noch mehr, beispielsweise sechs bis acht. Der Verlauf der Zacken bzw. Ausbuchtungen über die Länge des Sensorelementkörpers hinweg bildet somit eine Art von schräg stehenden Rippen, wobei diese Rippen an einen innenliegenden Abschnitt des Sensorelementkörpers derart einteilig bzw. einstückig angeformt sind, dass er homogen und einteilig ist.

Vorgenannte Zacken oder Ausbuchtungen können beispielsweise ein Stück über die Ausnehmungen dazwischen überstehen, beispielsweise 5% bis 30% des Durchmessers. Besonders vorteilhaft können sie zwischen 10% und 20% überstehen, so dass einerseits ein ausreichend großer Anteil des Sensorelementkörpers auf die Ausbuchtungen bzw. die von diesen gebildeten Längsrippen verteilt ist. Andererseits ist ein im inneren Bereich liegender Anteil des Sensorelementkörpers nicht vernachlässigbar klein, so dass er noch eine ausreichende Stabilität für den Sensorelementkörper gewährleistet. Vorteilhaft sind die Stirnflächen des Sensorelementkörpers gleich ausgebildet.

Ein vorbeschriebener Sensorelementkörper kann in Ausgestaltung der Erfindung aus Schaumgummi oder Schaumstoff bestehen, beispielsweise aus Polymeren bzw. Elastomeren. Er ist vorteilhaft elastisch kompressibel und elektrisch leitfähig, wie dies an sich aus dem Stand der Technik bekannt ist. Hergestellt werden kann ein solches Sensorelement bzw. ein Sensorelementkörper durch Extrudieren, wobei während des Extrudierens die genannte Verdrehung bzw. Verdrillung erfolgt.

Der Sensorelementkörper kann eine Ausnehmung aufweisen zwischen den beiden Stirnflächen, in der beispielsweise eine Beleuchtung wie eine LED untergebracht sein kann. Besonders vorteilhaft ist eine derartige Ausnehmung zylindrisch bzw. entlang der Mittellängsachse vorgesehen und nimmt etwa 10% bis 20% einer Stirnfläche ein. Sie kann eine Innenkontur aufweisen, die ähnlich ist zu derjenigen der Außenkontur oder ihr sogar entspricht, vorteilhaft ebenso verdrillt ist.

Bei einer eingangs genannten Bedienungseinrichtung mit mehreren vorbeschriebenen Sensorelementen sind die Sensorelemente auf einem Träger angeordnet, beispielsweise auf einer Leiterplatte. Eine elektrische Kontaktierung von dem Träger an die Sensorelemente kann so erfolgen, wie es aus dem Stand der Technik bekannt ist. Auf die andere Stirnfläche der Sensorelementkörper wird eine Abdeckung oder Bedienfläche aufgebracht und dann werden die Sensorelemente zwischen Abdeckung und Träger zusammengedrückt und fixiert bzw. mit einem vorgegebenen Abstand befestigt. Hierbei können die Sensorelemente beispielsweise um einen Teil ihrer Längserstreckung zusammengedrückt werden, beispielsweise 2% bis 40%, insbesondere etwa 20%.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Schrägansicht auf ein Sensorelement gemäß der Erfindung mit abgerundet sternförmigem Querschnitt des Sensorelementkörpers, wobei der Sensorelementkörper über seine Längserstreckung gleichmäßig verdrillt ist,

- Fig. 2: das Sensorelement aus Fig. 1 im zusammengedrückten Zustand,
- Fig. 3: einen eckig sternförmigen Querschnitt einer alternativen Ausführung eines Sensorelements und
- Fig. 4: das Sensorelement gemäß Fig. 1 und 2 eingebaut in eine Bedienungseinrichtung mit einem kapazitiven Berührungsschalter.

### Detaillierte Beschreibung der Ausführungsbeispiele

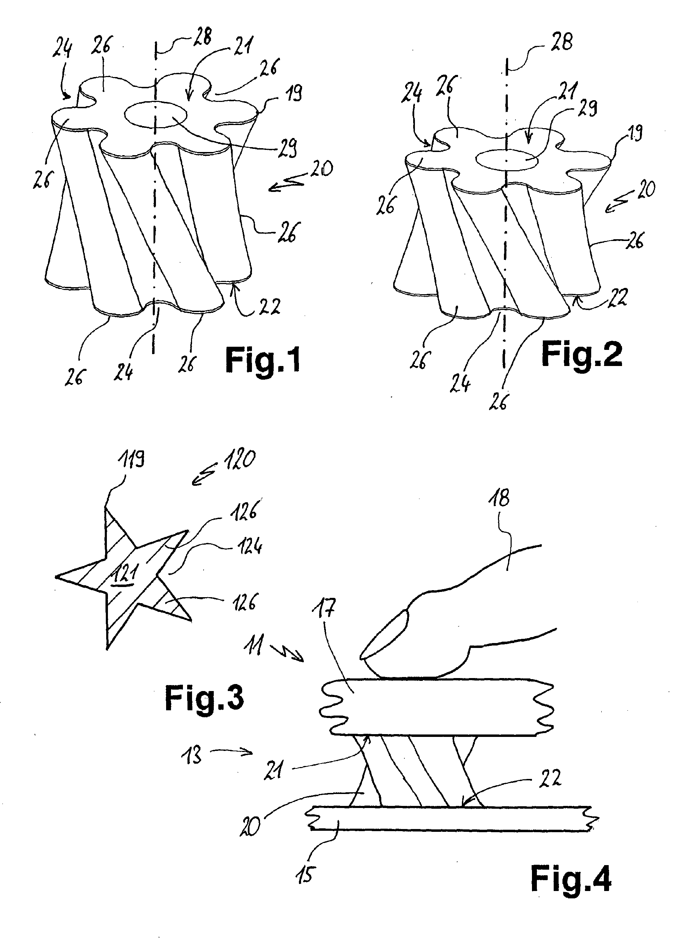

In Fig. 1 ist ein erfindungsgemäßes Sensorelement 20 mit einem Sensorelementkörper 19 dargestellt. Der Sensorelementkörper 19 weist eine obere Stirnfläche 21 und eine untere Stirnfläche 22 auf. Die Stirnflächen 21 und 22 sind gleich ausgebildet und weisen jeweils sechs gleichmäßige Ausnehmungen 24 sowie dazwischenliegende Ausbuchtungen 26 auf, so dass sich für die Stirnfläche die Form einer Blume bzw. eines stark abgerundeten Sterns ergibt. Entlang einer strichpunktiert dargestellten Mittellängsachse 28 weist der Sensorelementkörper 19 stets dieselbe Querschnittsfläche auf mit den Ausnehmungen 24 und den Ausbuchtungen 26. Allerdings ist der gesamte Sensorelementkörper 19 sozusagen verdreht bzw. verdrillt und zwar in etwa um einen Drehwinkel von 45°. Bei einer Herstellung eines solchen Sensorelementkörpers 19 aus einem vorgenannten elastischen Material kann dies durch Drehen einer Form beim Extrudieren erfolgen oder durch Drehen des nach der Form vorliegenden langen Strangs, aus dem die einzelnen Sensorelemente 20 durch Abschneiden erhalten werden.

Wie auch aus Fig. 1 zu erkennen ist, ist der Querschnitt des Sensorelementkörpers 19 bzw. sind die beiden Stirnflächen 21 und 22 symmetrisch sowie gleichmäßig ausgebildet. Dadurch ist es möglich, sie ohne Einhalten einer bestimmten Drehposition zu montieren, wie nachfolgend noch näher dargestellt wird.

Entlang der Mittellängsachse 28 verläuft ein Loch 29 als durchgehende Bohrung. Dieses Loch 29 kann ebenfalls beim Herstellen bzw. Extrudieren des Sensorelements 20 hergestellt werden. Es dient dazu, wie aus dem Stand der Technik bekannt, eine Beleuchtung bzw. eine LED darin anzuordnen, die nach oben durch das Loch 29 hindurchstrahlt. Des Weiteren kann auch durch dieses Loch 29 eine leichtere Zusammendrückbarkeit erreicht werden.

In Fig. 2 ist das Sensorelement 20 aus Fig. 1 im leicht zusammengedrückten Zustand dargestellt. Es ist um etwa 20% zusammengedrückt. Wie zu erkennen ist, bleibt die Form im Wesentlichen gleich, nur das die Höhe eben gestaucht ist. Vor allem aber ändert sich an den Stirnflächen 21 und 22 sowie allgemein am Querschnitt nahezu nichts. Je nach Material für das Sensorelement 20 kann eine gewisse Verbreiterung stattfinden in Folge des Zusammendrückens. Bei geschäumten Materialien, insbesondere geschlossenporigen Materialien, kann eine solche Verbreiterung sogar noch stärker stattfinden.

In Fig. 3 ist ein abgewandeltes Sensorelement 120 im Querschnitt dargestellt. Der Querschnitt sowie die Stirnflächen sind nach Art eines gleichmäßigen fünfzackigen Sterns ausgebildet, wobei die Zacken die Ausbuchtungen 126 bilden und dazwischen die Ausnehmungen 124 sind. Auch das Sensorelement 120 gemäß Fig. 3 ist gemäß einer Mittellängsachse verdreht ausgebildet entsprechend der Sensorelemente aus den Fig. 1 und 2, was allerdings hier nicht dargestellt ist.

In Fig. 4 ist eine Bedienungseinrichtung 11 dargestellt mit einem kapazitiven Berührungsschalter 13. Dieser wird gebildet durch das Sensorelement 20, welches mit seiner unteren Stirnfläche 22 an der Oberseite einer Leiterplatte 15 anliegt. Mit seiner oberen Stirnfläche 21 liegt es an der Unterseite einer Bedienfläche 17 an, beispielsweise einer Glaskeramikplatte eines Kochfelds, für das die Bedienungseinrichtung 11 vorgesehen ist. Wie aus dem Stand der Technik, insbesondere der EP 859 467 A1 bekannt, erfolgt eine elektrische Kontaktierung beispielsweise über ein nicht dargestelltes, elektrisch leitfähiges Feld auf der Oberseite der Leiterplatte 15 mittels der unteren Stirnfläche 22 an das elektrisch leitfähige Sensorelement 20. Die obere Stirnfläche 21 bildet im Bereich der Berührung mit der Unterseite der Bedienfläche 17 die Sensorelementfläche bzw. eine Platte eines Kondensators für den kapazitiven Berührungsschalter 13. Durch Auflegen eines Fingers 18 auf die Stelle oberhalb des Sensorelements 20 bzw. oberhalb der oberen Stirnfläche 21 erfolgt eine Bedienung, welche durch eine mit dem Sensorelement 20 verbundene, hier nicht dargestellte Steuerung, beispielsweise auf der Leiterplatte 15, erkannt werden kann.

Der wesentliche Unterschied zu bekannten Sensorelementen, beispielsweise gemäß der EP 859 467 A1, liegt gemäß Fig. 4 darin, dass durch das Verdrillen des Sensorelements 20 bzw. des Sensorelementkörpers 19 dieses leichter zusammengedrückt werden kann bzw. hierfür eine geringere Kraft notwendig ist. Des Weiteren kann das benötigte Material für das Sensorelement 20 eingespart werden. Durch ein Loch 29 in der Mitte kann eine notwendige Kraft zum Zusammendrücken weiter reduziert werden. Das Loch kann vorteilhaft ebenfalls mit einer verdrillten Kontur versehen werden, beispielsweise entsprechend der Außenkontur der Stirnflächen 21 und 22. Ein Verdrillen weist gegenüber einem geradlinigen Querschnitt mit Ausnehmungen 24 und Ausbuchtungen 26 den Vorteil auf, dass sich das Sensorelement 20 beim Zusammendrücken sozusagen in sich zusammenschrauben kann. Hier hat sich gezeigt, dass die notwendige Kraft zum Zusammendrücken gegenüber einem geradlinigen Querschnitt mit gleichen Stirnflächen deutlich reduziert werden kann. Gleichzeitig wird durch die Form der Stirnflächen, insbesondere der oberen Stirnfläche 21, die für den kapazitiven Berührungsschalter 13 von Bedeutung ist, eine ausreichend große Fläche geschaffen für die Funktion des kapazitiven Berührungsschalters.

## Patentansprüche

1. Sensorelement (20, 120) für einen kapazitiven Berührungsschalter (13) mit einem Sensorelementkörper (19, 119), dessen Form an einem ersten Ende eine erste Stirnfläche (21, 121) und an einem zweiten anderen Ende eine zweite Stirnfläche (22) aufweist und der aus weitgehend homogenen Material besteht, **dadurch gekennzeichnet, dass** die Form des Sensorelementkörpers (19, 119) von einer reinen Zylinderform abweicht durch Ausnehmungen (24, 124) und/oder Ausbuchtungen (26, 126) seiner Außenkontur, wobei sich die Ausnehmungen (24, 124) und/oder Ausbuchtungen (26, 126) über die Länge des Sensorelementkörpers (19, 119) in Richtung von der ersten Stirnfläche (21, 121) zur zweiten Stirnfläche (22) erstrecken, wobei die Erstreckungsrichtung der Ausnehmungen und/oder Ausbuchtungen schräg ist zur Mittellängsachse (28) des Sensorelementkörpers bzw. der Stirnflächen.

2. Sensorelement nach Anspruch 1, **dadurch gekennzeichnet, dass** die Erstreckungsrichtung sämtlicher Ausnehmungen (24, 124) und/oder Ausbuchtungen (26, 126) den gleichen Schrägwinkel zur Mittellängsachse (28) des Sensorelementkörpers (19, 119) bzw. zu den Stirnflächen (21, 22, 121) aufweist.

3. Sensorelement nach Anspruch 1 oder 2, **dadurch gekennzeichnet, dass** der Sensorelementkörper (19, 119) einen Querschnitt mit einer von einem Kreis abweichenden Kontur bzw. Form aufweist, wobei insbesondere der Sensorelementkörper (19, 119) in Richtung zwischen den Stirnflächen (21, 22, 121) einen unrunden Querschnitt mit stets derselben Form aufweist, wobei sich vorzugsweise die Querschnittsform entlang der Mittellängsachse (28) des Sensorelementkörpers (19, 119) zwischen den Stirnflächen (21, 22, 121) um die Mittellängsachse (28) dreht.

4. Sensorelement nach Anspruch 3, **dadurch gekennzeichnet, dass** der Sensorelementkörper (19, 119) mit dem unrunden Querschnitt verdreht bzw. verdrillt ist, insbesondere in ausschließlich einer Richtung und vorzugsweise gleichmäßig verdreht ist.

5. Sensorelement nach Anspruch 3 oder 4, **dadurch gekennzeichnet, dass** der Querschnitt regelmäßig ausgebildet ist, insbesondere nach Art eines Sterns mit Ausbuchtungen (26, 126) bzw. Zacken und Ausnehmungen (24, 124) dazwischen, wobei vorzugsweise zwischen fünf und zwölf Zacken (26, 126) vorgesehen sind.

6. Sensorelement nach Anspruch 4 oder 5, **dadurch gekennzeichnet, dass** die Ausbuchtungen bzw. Zacken (26, 126) zwischen 5% und 30% des Durchmessers über die Ausnehmungen (24, 124) überstehen, vorzugsweise zwischen 10% und 20%.

7. Sensorelement nach einem der vorhergehenden Ansprüche, **dadurch gekennzeichnet, dass** eine Verdrehung bzw. Verdrillung einen Drehwinkel von mindestens 30° aufweist, vorzugsweise 45° bis 60°.

8. Sensorelement nach einem der vorhergehenden Ansprüche, **dadurch gekennzeichnet, dass** der Sensorelementkörper (19, 119) aus Schaumgummimaterial oder Schaumstoffmaterial besteht und elastisch kompressibel ist und eine elektrische Leitfähigkeit aufweist, wobei er vorzugsweise aus extrudiertem Schaumgummi besteht.

9. Sensorelement nach einem der vorhergehenden Ansprüche, **gekennzeichnet durch** eine mittige Ausnehmung (29) entlang einer Mittellängsachse (28) des Sensorelementkörpers (19).

10. Sensorelement nach Anspruch 9, **dadurch gekennzeichnet, dass** die mittige Ausnehmung (29) eine Innenkontur aufweist, die der Außenkontur entspricht, vorzugsweise ebenso verdrillt ist.

11. Bedienungseinrichtung (11) für ein Elektrogerät mit mehreren Sensorelementen (20, 120) nach einem der vorhergehenden Ansprüche, **dadurch gekennzeichnet, dass** die Sensorelemente (20, 120) auf einem Träger (15) angeordnet sind unter einer Abdeckung (17), wobei die Sensorelemente (20, 120) mit ihren Stirnflächen (21, 22, 121) von dem Träger (15) und der Abdeckung (17) mit einer Druckkraft um einen Teil zusammengedrückt sind.

12. Bedienungseinrichtung (11) nach Anspruch 11, **dadurch gekennzeichnet, dass** die Sensorelemente (20, 120) mit ihren Stirnflächen (21, 22, 121) von dem Träger (15) und der Abdeckung (17) mit einer Druckkraft um 2% bis 40%, zusammengedrückt sind, insbesondere etwa 20%.
